# EUROPEAN PATENT APPLICATION

(11) **EP 4 583 240 A1**
(43) Date of publication of application: **09.07.2025**
(21) Application number: 25150141.7
(22) Date of filing: 03.01.2025
(51) Int. Cl.: H01M 10/42, H01M 50/105, H01M 50/202, H01M 50/588

(54) **POUCH BATTERY**

(30) Priority: 04.01.2024 KR 20240001517
(71) Applicant: SAMSUNG SDI CO., LTD., Yongin-si, Gyeonggi-do 17084 (KR)
(72) Inventor: Kim, Youngjun, 17084 Yongin-si, Gyeonggi-do (KR)
(74) Representative: Gulde & Partner

(57) **Abstract**

A battery pack (1) includes a battery cell (20) and a pouch (30) accommodating the battery cell (20). The pouch (30) includes a terrace (31) extending in a first direction in which an electrode of the battery cell (20) is drawn out. The pouch (30) also includes a substrate (50) including a protection element (500) on a first surface (51) configured to control charging and discharging of the battery cell (20). A second surface (52) opposing the first surface (51) is opposite to a module seating surface (311) of the terrace (31). The pouch (30) also includes a molding portion (70) covering the protection element (500) on the first surface (51), and a support (60) between the molding portion (70) and the substrate (50) and configured to support the substrate (50).

## Description

### BACKGROUND

### 1. Field

One or more embodiments relate to a battery pack.

### 2. Description of the Related Art

Secondary batteries refer to batteries that can be charged and discharged a plurality of times so as to be used repeatedly. Secondary batteries are used as energy sources for mobile devices, electric vehicles, hybrid vehicles, electric bicycles, uninterruptible power supplies, etc. Depending on the type of an external device they are applied to, the secondary batteries may be used in the form of a single battery or in the form of a pack in which multiple battery cells are connected and grouped into one unit or module.

The information disclosed in this Background of the disclosure is only to facilitate understanding of the background of the disclosure, and therefore may include information that does not constitute prior art.

### SUMMARY

One or more embodiments include a battery pack including a support configured to prevent a substrate from being damaged.

One or more embodiments include a battery pack including a support spaced apart from a protection element on a surface of a substrate.

Additional aspects will be set forth in part in the description which follows and, in part, will be apparent from the description, or may be learned by practice of the presented embodiments of the present disclosure.

According to one or more embodiments, a battery pack includes a battery cell and a pouch accommodating the battery cell. The pouch includes a terrace along a portion of the pouch in which an electrode of the battery cell extends out of the pouch in a first direction. The pouch also includes a substrate including a protection element on a first surface of the substrate. The protection element is configured to control charging and discharging of the battery cell. A second surface of the substrate opposite to the first surface of the substrate is opposite to a module seating surface of the terrace.

According to one or more embodiments, a battery pack includes a battery cell, a pouch covering the battery cell and including a terrace formed in a first direction in which an electrode of the battery cell is drawn out, a substrate including a protection element arranged on a first surface to control charging and discharging of the battery cell, in which a second surface opposing the first surface is arranged opposite to a module seating surface of the terrace, a molding portion covering the protection element on the first surface, and a support arranged between the molding portion and the substrate and configured to support the substrate.

The substrate, the molding portion, and the support may form a protection circuit module.

The module seating surface may extend in a second direction crossing the first direction on the pouch (may be arranged in a second direction intersecting the first direction on the pouch).

The substrate may extend in a third direction crossing the first direction and the second direction (may extend in a third direction intersecting the first direction and the second direction).

The support may extend in the third direction.

The battery pack may include two or more supports (may be provided in plural).

The two or more supports may be spaced apart from each other on the first surface of the substrate in the first direction (may be arranged to be spaced apart from each other in a first direction on the first surface of the substrate).

The support may not contact the protection element on the first surface of the substrate (may be arranged not to contact the protection element on the first surface of the substrate).

The support may include a through-hole structure accommodating the protection element (may include a through-hole structure to avoid a region in which the protection element is arranged).

The support may include a metal material.

The terrace, the substrate, and the molding portion may overlap in the second direction (may be arranged to overlap in the second direction).

The terrace, the substrate, and the molding portion may be arranged in the stated order in the second direction.

The substrate may be on the terrace and the molding portion may be on the substrate in the second direction (may be arranged on the terrace and the molding portion may be arranged on the substrate in the second direction).

The molding portion may include a thermally conductive material configured to discharge heat emitted from the substrate to an outside of the protection circuit module (may include a thermally conductive material capable of discharging heat emitted from the substrate to outside of the protection circuit module).

The substrate may further include a connection tab on the second surface and electrically connected to the electrode of the battery cell (may further include a connection tab arranged on the second surface and electrically connected to the electrode of the battery cell).

All embodiments described in this specification may be advantageously combined with one another to the extent that their respective features are compatible. In particular, the expressions "according to an embodiment," "in an embodiment," "an embodiment of the invention provides" etc. mean that the respective features may or may not be part of specific embodiments of the present invention.

### BRIEF DESCRIPTION OF THE DRAWINGS

The above and other aspects, features, and advantages of certain embodiments of the present disclosure will be more apparent from the following description taken in conjunction with the accompanying drawings, in which:
FIG. 1 is a perspective view of a battery pack according to embodiments;
FIG. 2 is an assembly view of a battery pack according to embodiments;
FIG. 3 is a view for describing a terrace of a pouch according to embodiments;
FIG. 4 is a view for describing a connection tab arranged on a substrate according to embodiments;
FIG. 5A is a view for describing a support arranged on a substrate according to embodiments;
FIG. 5B is a view for describing a support arranged on a substrate according to embodiments;
FIG. 5C is a view for describing a support arranged on a substrate according to embodiments;
FIG. 6 is a coupling view of a molding portion and a substrate according to embodiments;
FIG. 7 is a view for describing a molding portion formed on a substrate according to embodiments;
FIG. 8 is a view for describing a structure in which a protection circuit module is connected to a first electrode and a second electrode of a battery cell, according to embodiments; and
FIG. 9 is view for describing a structure in which a protection circuit module is arranged on a terrace of a pouch, according to embodiments.

### DETAILED DESCRIPTION

Reference will now be made in detail to embodiments, examples of which are illustrated in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figures, to explain aspects of the present description. As used herein, the term "and/or" includes any and all combinations of one or more of the associated listed items.

Hereinafter, embodiments of the present disclosure will be described in detail with reference to the accompanying drawings. The terms and words used in the present specification and claims described above should not be construed as being limited to ordinary or dictionary meanings, and should be interpreted as meanings and concepts consistent with the technical idea of the present disclosure based on the principle that the present inventors may appropriately define the concept of the terms to describe their invention in the best way. Therefore, it should be understood that the configurations shown in the drawings and embodiments described in this specification are merely the most preferred embodiments of the present disclosure, and do not represent all of the technical ideas of the present disclosure, such that there may be various equivalents and variations that replace them at the time of filing the present application. If used herein, "comprise, include" and/or "comprising, including" specify mentioned shapes, numbers, steps, operations, members, components, and/or presence of these groups, and do not exclude the presence or addition of one or more different shapes, numbers, operations, members, components, and /or groups. When embodiments of the present disclosure are described, "can" or "may" may include "one or more embodiments of the present disclosure".

To help understanding of the present disclosure, the accompanying drawings are not shown according to the actual scale, but the dimensions of some components may be exaggerated. The same reference numeral may be given to the same component in different embodiments.

The statement that two comparison targets are 'the same' as each other may mean that they are 'substantially the same' as each other. Thus, a case where they are 'substantially the same' as each other may include a case where they have a deviation regarded as a low level, e.g., a deviation of 5 % or less. If a uniform parameter is uniform in a predetermined area, it may mean that it is uniform from an average point of view.

Although 1st, 2nd, etc., may be used to describe various components, these components are not limited by these terms. These terms are only used to distinguish one component from other components, and unless specifically stated to the contrary, a first component may be a second component.

Throughout the specification, unless specially stated to the contrary, each component may be singular or plural.

If a component is arranged on "a top portion (or a bottom portion)" of another component or "on (or under)" the other component, it may mean not only a case where the component is arranged adjacent to a top surface (or a bottom surface) of the other component, but also a case where another component may be interposed between the other component and the component arranged on (or under) the other component.

If a component is described as being "connected", "coupled", or "connected" to another component, it should be understood that the components are directly connected or connectable to each other, but another component may be "interposed" between the components, or the components may be may be "connected", "coupled", or "connected" to each other through another component. If a portion is electrically coupled to another portion, this may include not only a case where they are directly connected to each other, but also a case where they are connected with another element therebetween.

Throughout the specification, "A and/or B" may mean A, B, or A and B unless specially stated otherwise. That is, "and/or" may include all or any combination of a plurality of items listed. "C to D" may mean at least C but not more than D, unless specially stated otherwise.

Hereinafter, a battery pack according to embodiments of the present disclosure will be described with reference to the accompanying drawings.

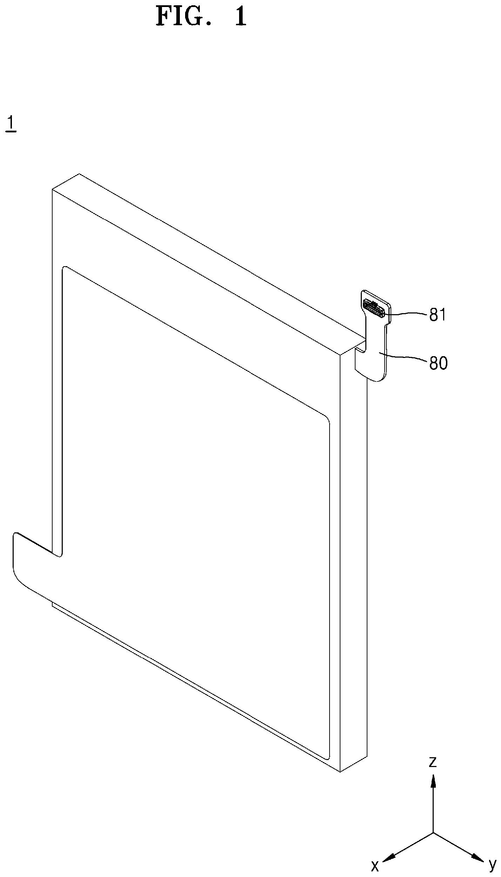

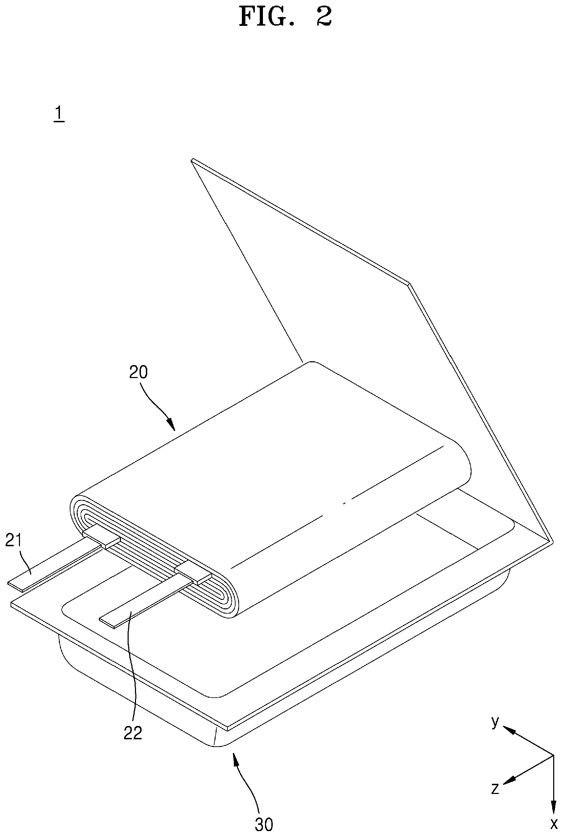

FIG. 1 is a perspective view of a battery pack 1 according to embodiments of the present disclosure. FIG. 2 is a perspective view of the battery pack 1 during assembly according to embodiments of the present disclosure.

Referring to FIGS. 1 and 2, the battery pack 1 according to embodiments of the present disclosure may include a battery cell 20. The battery cell 20 may include a negative plate, a positive plate, and a separator between the negative plate and the positive plate. A negative tab electrically connected to a negative uncoated portion of the negative plate may be on or in the negative plate, and a positive tab electrically connected to a positive uncoated portion of the positive plate may be on or in the positive plate. The negative tab may be a first electrode 21. The positive tab may be a second electrode 22. The battery cell 20 may be, but not limited to, an electrode assembly including the first electrode 21 and the second electrode 22.

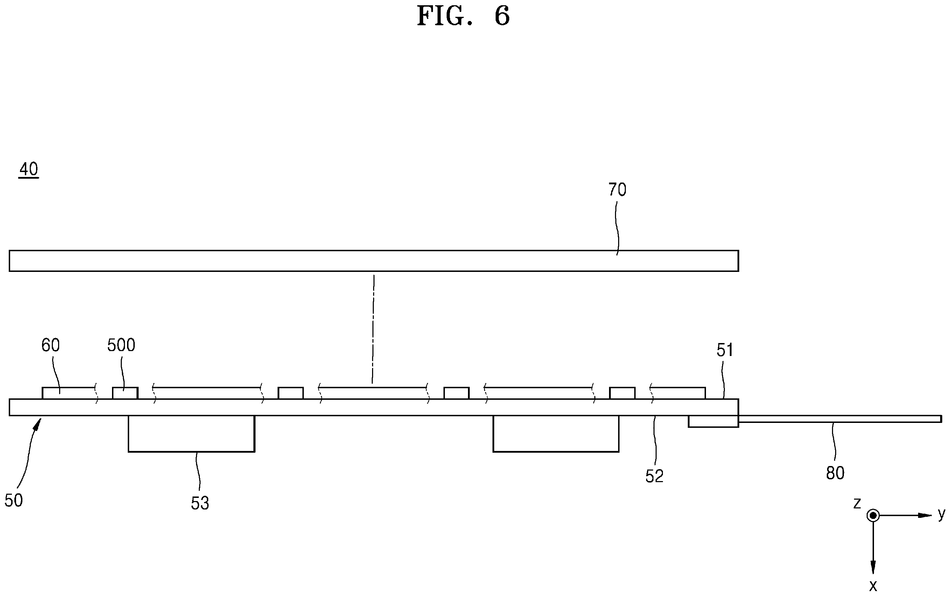

The battery pack 1 according to embodiments of the present disclosure may include a pouch 30 configured to accommodate the battery cell 20. The pouch 30 may accommodate the battery cell 20. The battery cell 20 may be accommodated inside the pouch 30. The pouch 30 may cover the battery cell 20. The pouch 30 may expose at least a portion of each of the first electrode 21 and the second electrode 22. At least a portion of each of the first electrode 21 and the second electrode 22 may be exposed to outside of the pouch 30. The portions of first electrode 21 and the second electrode 22 exposed to the outside of the pouch 30 may be electrically connected to the protection circuit module 40 described later with reference to FIG. 6.

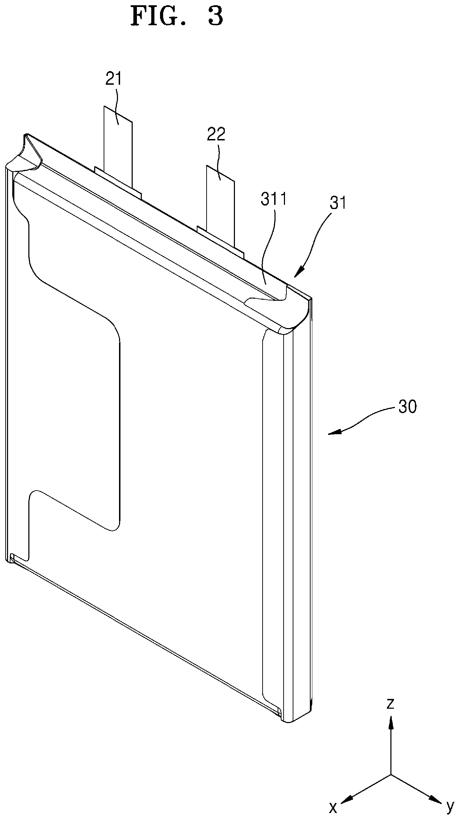

FIG. 3 depicts a terrace 31 of the pouch 30 according to embodiments of the present disclosure. FIG. 3 depicts the pouch 30 of FIG. 2 with each corner sealed.

Referring to FIGS. 2 and 3, the first electrode 21 and the second electrode 22 of the battery cell 20 according to embodiments of the present disclosure may be drawn out in a first direction (z-axis). The first direction (z-axis direction) may be an upward direction of the pouch 30. The first electrode 21 and the second electrode 22 of the battery cell 20 may be drawn out in the upward direction (z-axis direction) of the pouch 30.

The pouch 30 according to embodiments of the present disclosure may include the terrace 31 formed thereon. The pouch 30 may include the terrace 31 formed in the first direction (z-axis direction) in which the first electrode 21 and the second electrode 22 of the battery cell 20 are drawn out. The terrace 31 may be a portion in which the protection circuit module 40 described below with reference to FIG. 6 is arranged or located.

The terrace 31 according to embodiments of the present disclosure may include a module seating surface 311 provided in a direction facing a front surface of the pouch 30. The module seating surface 311 may be a surface of the terrace 31 arranged in the direction facing the front surface of the pouch 30. The module seating surface 311 may be a surface of the terrace 31 extending lengthwise in an transverse or widthwise direction (y-axis direction). The module seating surface 311 may be a portion in which the protection circuit module 40 described below with reference to FIG. 6 is arranged or located. However, the foregoing and following description of the arrangement and functions of the terrace 31 and the module seating surface 311 is merely one embodiment and the present disclosure is not limited thereto.

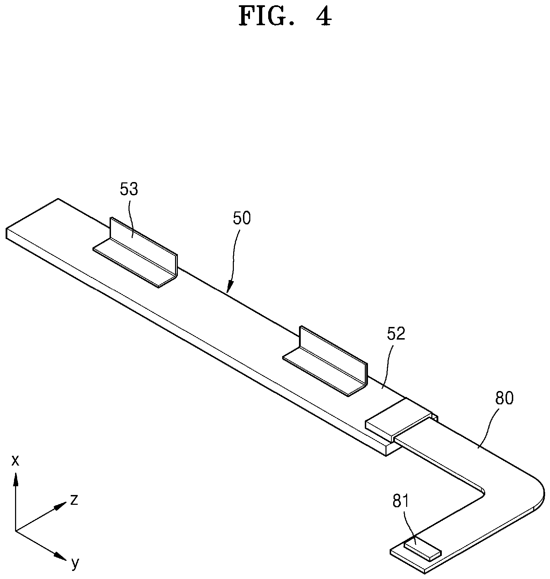

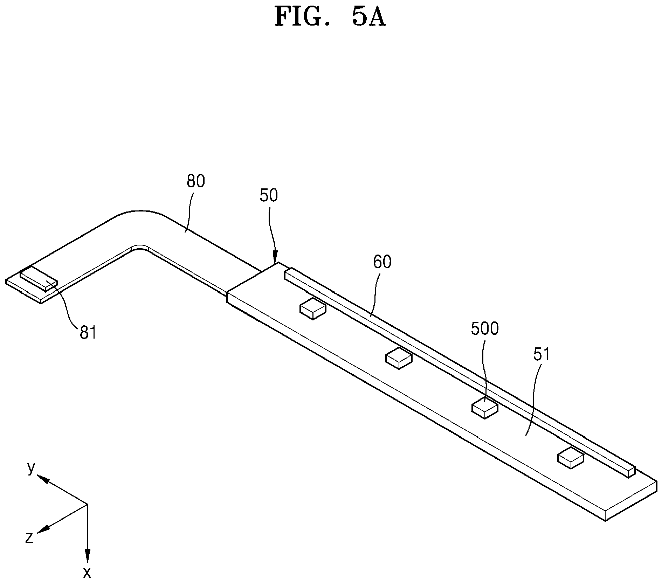

FIG. 4 depicts a connection tab 53 arranged on a substrate 50 according to embodiments of the present disclosure. FIG. 5A depicts a support 60 on the substrate 50 according to embodiments of the present disclosure.

Referring to FIGS. 3 to 5A, the battery pack 1 according to embodiments of the present disclosure may include the substrate 50 configured to be arranged on the module seating surface 311 of the terrace 31. The substrate 50 may include a first surface 51 (see FIG. 5A) and a second surface 52 (see FIG. 4) opposite to the first surface 51. The substrate 50 may include a protection element 500 on the first surface 51 to control charging/discharging of the battery cell 20. The protection element 500 may control charging and discharging of the battery cell 20. The protection element 500 may be electrically connected to the battery cell 20. The protection element 500 may selectively block or allow power supplied to the battery cell 20. The protection element 500 may prevent excessive power from being supplied to the battery cell 20. The protection element 500 may also be configured to prevent (or at least mitigate) the battery cell 20 from being degraded due to excessive power being supplied to the battery cell 20. However, the arrangement and functions of the protection element 500 may not be limited to the foregoing description.

The substrate 50 according to embodiments of the present disclosure may include connection tabs 53 electrically connected to a first terminal and a second terminal of the battery cell 20. The connection tabs 53 may be on a second surface 52 of the substrate 50. The connection tabs 53 may be on a surface of the substrate 50 opposite to the surface of the substrate 50 on which the protection element 500 is arranged. However, arrangement of the connection tabs 53 is not limited to the foregoing description.

Additionally, in one or more embodiments, for weight reduction and miniaturization of the battery pack 1, the thickness of the substrate 50 may not exceed a threshold thickness. In an embodiment in which the thickness of the substrate 50 is minimized or at least reduced, the battery pack 1 may not be excessively heavy. In an embodiment in which the thickness of the substrate 50 does not exceed a threshold thickness, the size of the battery pack 1 may not be excessively large. The thickness of the substrate 50 may be the thickness of the substrate 50 measured in a second direction (x-axis direction). The second direction (x-axis direction) may intersect or cross the first direction (z-axis direction) in which an electrode of the battery cell 20 is drawn out. The second direction (x-axis) may be perpendicular to the first direction (z-axis direction). The second direction (x-axis) may perpendicularly traverse or cross the first surface 51 and the second surface 52 of the substrate 50. The thickness of the substrate 50 may be a shortest distance between the first surface 51 and the second surface 52. The thickness of the substrate 50 may be a shortest distance between a surface of the substrate 50 on which the protection element 500 is located and the other surface of the substrate 50 on which the connection tabs 53 are located. However, the foregoing description of the thickness of the substrate 50 is merely an embodiment and the present disclosure is not limited thereto.

The substrate 50 according to embodiments may extend lengthwise in a third direction (y-axis). The third direction y may intersect the first direction (z-axis) in which the first and second electrodes 21, 22 of the battery cell 20 are drawn out. The third direction (y-axis) may be perpendicular to the first direction (z-axis). The third direction (y-axis) may intersect the second direction (x-axis) and perpendicularly traverse or cross the first surface 51 and the second surface 52 of the substrate 50 of the battery cell 20. The third direction (y-axis) may be perpendicular to the second direction (x-axis). The third direction (y-axis) may intersect the first direction (z-axis) and the second direction (x-axis). The third direction (y-axis) may be perpendicular to the first direction (z-axis) and the second direction (x-axis). In an embodiment in which the substrate 50 extends lengthwise in the third direction (y-axis), the size of the substrate 50, measured in the third direction (y-axis), may be greater than the size of the substrate 50, measured in the second direction (x-axis) and the first direction (z-axis). In one or more embodiments, the size of the substrate 50 in the third direction (y-axis) may be less than or equal to approximately 3 times to approximately 30 times the size of the substrate 50 in the first direction (z-axis). That is, the ratio of the length of the substrate 50 to the width of the substrate 50 may be less than or equal to a value in a range from approximate 3 to approximately 30. The size of the substrate 50 in the third direction (y-axis) may be less than or equal to approximately 5 times to approximately 10 times the size of the substrate 50 in the second direction (x-axis). That is, the ratio of the length of the substrate 50 to the thickness of the substrate 50 may be less than or equal to a value in a range from approximately 5 to approximately 10. The size of the substrate 50 in the third direction (y-axis) may be less than or equal to 10 times to 200 times the size of the substrate 50 in the second direction (x-axis). The size of the substrate 50 in the third direction (y-axis) may be less than or equal to 20 times to 100 times the size of the substrate 50 in the second direction (x-axis). However, the foregoing description of the form of the substrate 50 is merely an embodiment, and the present disclosure is not limited thereto.

In an embodiment in which the substrate 50 according to embodiments of the present disclosure extends lengthwise in the third direction (y-axis), the substrate 50 may be prevented from being damaged by an external force. In an embodiment in which the substrate 50 extends lengthwise in the third direction (y-axis), it may be desirable to prevent an excessive torque from being exerted on the substrate 50. In an embodiment in which the substrate 50 extends lengthwise in the third direction (y-axis), it may be desirable to prevent an excessive shear stress from being exerted on the substrate 50. Various forces as well as the foregoing forces may be exerted on the substrate 50. In one or more embodiments, a force generated by the weight of the substrate 50 may be exerted on the substrate 50. Hereinbelow, the support 60, which is configured to prevent or at least mitigate damage to the substrate 50, will be described.

The battery pack 1 according to embodiments of the present disclosure may include the support 60. The battery pack 1 may include the support 60 that is configured to support the substrate 50. The support 60 may be configured to reinforce the strength of the substrate 50. The support 60 may prevent an excessive torque from being exerted on the substrate 50. The support 60 may prevent an excessive shear stress from being exerted on the substrate 50. The support 60 may prevent the substrate 50 from being deformed by an external force. The support 60 may prevent the substrate 50 from being damaged. However, the function of the support 60 is not limited to the foregoing description.

The support 60 according to embodiments of the present disclosure may extend lengthwise in a direction in which the substrate 50 extends lengthwise. The support 60 may extend in the third direction (y-axis). The support 60 and the substrate 50 may each extend in the third direction (y-axis). Opposite ends of the support 60 in a longitudinal direction (i.e., opposite ends in the y-axis direction) may be respectively arranged toward opposite ends of the substrate 50 in the longitudinal direction (y-axis direction). The extending direction of the support 60 and the extending direction of the substrate 50 may be aligned or substantially aligned with each other. In an embodiment in which the lengthwise extending direction of the support 60 and the lengthwise extending direction of the substrate 50 are aligned with each other, an excessive force may be prevented or at least mitigated from being exerted on the substrate 50. If the lengthwise extending direction of the support 60 and the lengthwise extending direction of the substrate 50 are aligned with each other, damage to the substrate 50 may be prevented or at least mitigated. However, in one or more embodiments in which the extending direction of the support 60 and the extending direction of the substrate 50 are aligned or substantially aligned with each other, the support 60 and the substrate 50 may not extend in parallel to each other. In one or more embodiments in which the support 60 extends in a direction aligned or substantially aligned with the extending direction of the substrate 50, the support 60 and the substrate 50 may be arranged with an angle (within a predetermined angle range) between the extending direction of the support 60 and the extending direction of the substrate 50

The support 60 according to embodiments of the present disclosure may be on the first surface 51 of the substrate 50. The support 60 may support the substrate 50 on the first surface 51 of the substrate 50. The support 60 may support the substrate 50 on the first surface 51 of the substrate 50. However, the arrangement of the support 60 is not limited to the foregoing description. In one or more embodiments, the support 60 may be on the first surface 51 and the second surface 52 of the substrate 50.

The support 60 according to embodiments of the present disclosure may include a solid material. The support 60 may include a metal material. The support 60 may include a thermally conductive material. In an embodiment in which the support 60 includes a metal material, the support 60 may stably support the substrate 50. In an embodiment in which the support 60 includes the thermally conductive material, the support 60 may sufficiently or adequately discharge heat emitted from the substrate 50 to outside of the battery pack 1. However, the material of the support 60 is not limited to the foregoing description.

The protection element 500 and the support 60 may both be on the first surface 51 of the substrate 50 according to embodiments of the present disclosure. The support 60 may be spaced by a predetermined distance apart from the protection element 500 on the first surface 51 of the substrate 50. The support 60 may not contact the protection element 500 on the first surface 51 of the substrate 50. In an embodiment in which the support 60 does not contact the protection element 500, the support 60 may not be electrically connected to the protection element 500. In an embodiment in which the support 60 is spaced apart from the protection element 500, the support 60 may not be electrically connected to the protection element 500. However, the arrangement of the support 60 and the protection element 500 is not limited to the foregoing description. The support 60 may be spaced apart from an electric component on the substrate 50 as well as the protection element 500 such that the support 60 is not electrically connected to the electric component.

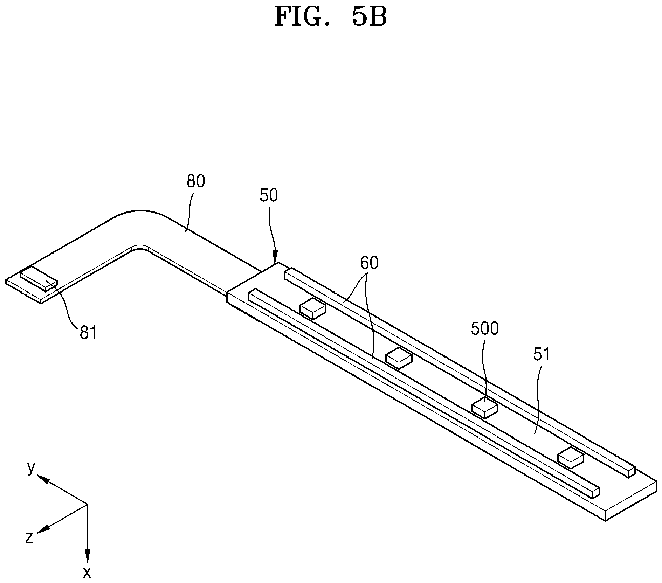

FIG. 5B depicts the support 60 on the substrate 50 according to embodiments of the present disclosure. Hereinafter, a description of the same components will be omitted and the description will focus on the differences between the embodiments.

Referring to FIGS. 3 to 5B, a plurality of supports 60 according to embodiments of the present disclosure may be provided. The plurality of supports 60 may be arranged on the first surface 51 of the substrate 50. The plurality of supports 60 may be arranged on the same surface of the substrate 50 as the protection element 500. The plurality of supports 60 may be arranged to avoid (e.g., not contact) the protection element 500 arranged on the substrate 50. Each of the plurality of supports 60 may be arranged to be spaced apart from the protection element 500 on the substrate 50. The plurality of supports 60 may be spaced apart from each other on the first surface 51 of the substrate 50 in the first direction (z-axis). In an embodiment in which the plurality of supports 60 are spaced apart from each other on the first surface 51 of the substrate 50 in the first direction (z-axis), they may avoid the protection element 500. In an embodiment in which the plurality of supports 60 are spaced apart from each other on the first surface 51 of the substrate 50 in the first direction (z-axis), they may not be electrically connected to the protection element 500. In an embodiment in which the plurality of supports 60 are spaced apart from each other on the first surface 51 of the substrate 50 in the first direction (z-axis), they may stably support the substrate 50 in a region not electrically connected to the protection element 500. However, arrangement of the plurality of supports 60 is not limited to the foregoing description. In one or more embodiments, the plurality of supports 60 may be spaced apart from each other on the first surface 51 of the substrate 50 in the second direction (x-axis). The arrangement of the plurality of supports 60 on the substrate 50 may be modified in various ways as long as the arrangement is capable of supporting the substrate 50 without connection to the protection element 500 on the substrate 50.

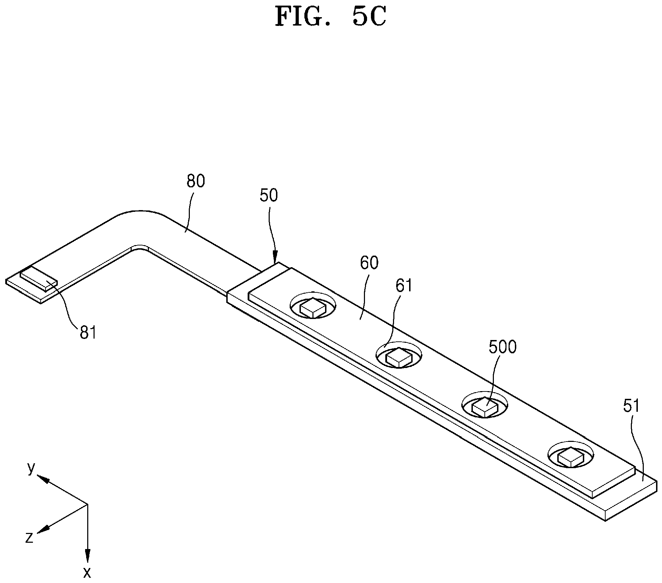

FIG. 5C is a view for describing the support 60 arranged on the substrate 50 according to embodiments.

Referring to FIGS. 3 to 5C, the support 60 according to embodiments of the present disclosure may include a through-hole structure 61. The support 60 may include the through-hole structure 61 to avoid the region or regions in which the protection element 500 is arranged. The through-hole structure 61 may define the region or regions in which the protection element 500 is arranged. The through-hole structure 61 may cover the protection element 500. The through-hole structure 61 may provide a space or spaces in which the protection element 500 is spaced apart from the support 60 to prevent the support 60 from being electrically connected to the protection element 500. The protection element 500 may be in the through-hole structure 61 of the support 60. The protection element 500 may not contact the support 60 in the through-hole structure 61 of the support 60. The support 60 may efficiently support the substrate 50 without contacting the protection element 500 due to the through-hole structure 61. The through-hole structure 61 may penetrate the surface of the support 60 in a thickness direction (x-axis direction) of the substrate 50. The through-hole structure 61 may penetrate the surface of the support 60 in the second direction (x-axis). The through-hole structure 61 of the support 60 shown in FIG. 5C is shown as being circular, but the shape of the through-hole structure 61 is not limited thereto. The support 60 may have various shapes including a polygonal shape provide that the support 60 is capable of supporting the substrate 50 without being connected to the protection element 500 on the substrate 50.

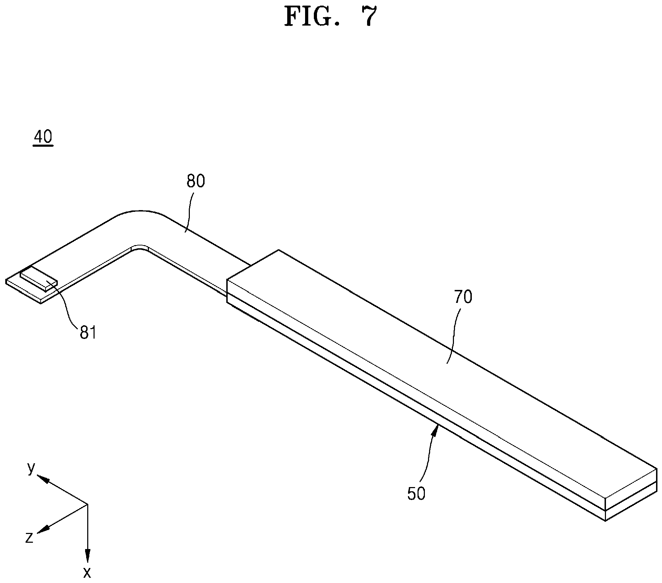

FIG. 6 depicts a molding portion 70 and the substrate 50 according to embodiments of the present disclosure. FIG. 7 depicts the molding portion 70 on the substrate 50 according to embodiments of the present disclosure.

Referring to FIGS. 4 to 7, the battery pack 1 according to embodiments may include a molding portion 70. The molding portion 70 may be on the first surface 51 of the substrate 50. The molding portion 70 may cover the protection element 500 on the substrate 50. The molding portion 70 may cover at least a portion of the support 60 on the substrate 50. The molding portion 70 may be on the same surface of the substrate 50 as the protection element 500. The molding portion 70 may be on the same surface of the substrate 50 as the support 60.

The molding portion 70 according to embodiments of the present disclosure may extend lengthwise in a direction in which the substrate 50 extends lengthwise. The molding portion 70 may include a solid material. The material of the molding portion 70 may include resin. The material of the molding portion 70 may include metal. The molding portion 70 may prevent or at least mitigate the substrate 50 from being deformed by an external force. However, the material and function of the molding portion 70 are not limited to the foregoing description.

Referring back to FIGS. 1 and 4 to 7, the battery pack 1 according to embodiments of the present disclosure may include a flexible circuit board 80 electrically connected to an end of the substrate 50. The flexible circuit board 80 may be electrically connected to the end of the substrate 50. A connector 81 communicating with an external device may be on the flexible circuit board 80. The connector 81 may electrically connect the external device to the battery cell 20. The flexible circuit board 80 may be flexible to enable a user to adjust a position of the connector 81. In an embodiment in which the flexible circuit board 80 is flexible, it may allow relative positions of the connector 81 and the substrate 50 to be adjusted.

Additionally, in one or more embodiments, the substrate 50, the molding portion 70, and the support 60 according to embodiments of the present disclosure may form a protection circuit module 40. The protection circuit module 40 may include the substrate 50, the molding portion 70, and the support 60. Hereinafter, a structure in which the protection circuit module 40 is arranged on the terrace 31 of the pouch 30 will be described.

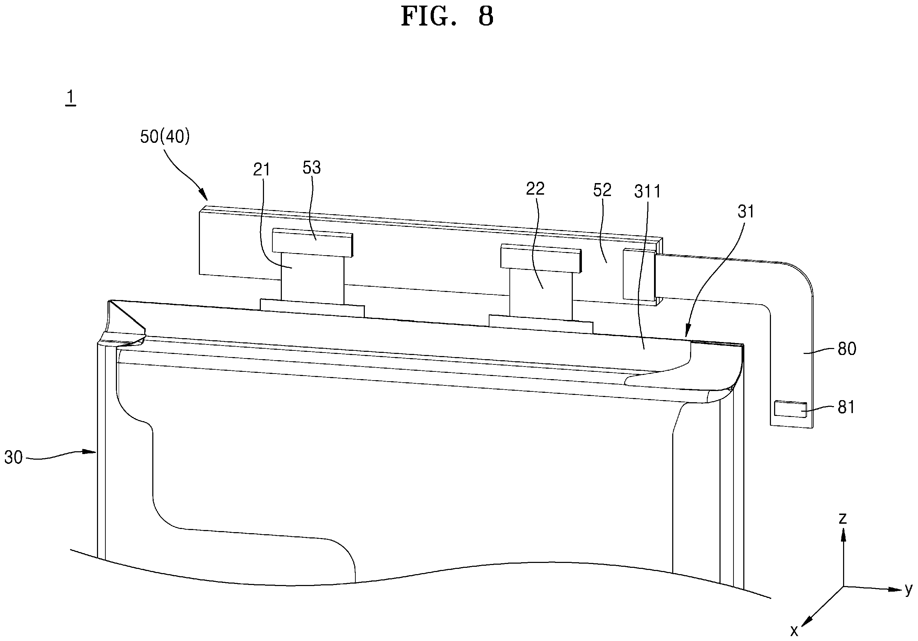

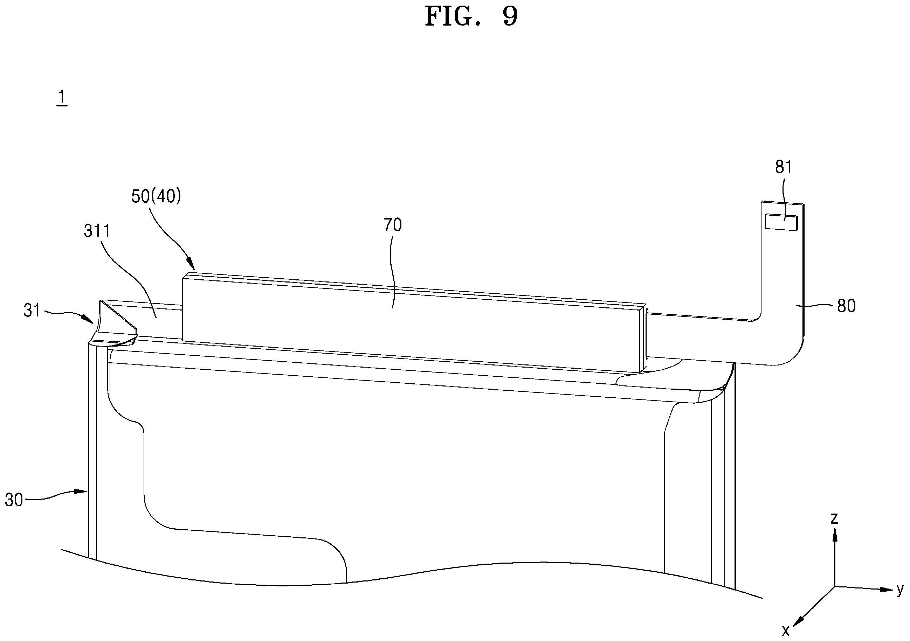

FIG. 8 depicts a configuration in which the protection circuit module 40 is connected to the first electrode 21 and the second electrode 22 of the battery cell 20, according to embodiments of the present disclosure. FIG. 9 depicts a configuration in which the protection circuit module 40 is on the terrace 31 of the pouch 30, according to embodiments of the present disclosure.

Referring to FIGS. 4 to 9, the connection tabs 53 on the substrate 50 according to embodiments of the present disclosure may be electrically connected to the first electrode 21 and the second electrode 22 of the battery cell 20. In an embodiment in which the connection tabs 53 are connected to the first electrode 21 and the second electrode 22 of the battery cell 20, the battery cell 20 may be electrically connected to the substrate 50. In an embodiment in which the connection tabs 53 are connected to the first electrode 21 and the second electrode 22 of the battery cell 20, the battery cell 20 may be electrically connected to the protection circuit module 40.

The protection circuit module 40 according to embodiments of the present disclosure may be on the terrace 31 of the pouch 30 by pivoting or rotating after the connection tabs 53 are connected to the first electrode 21 and the second electrode 22 of the battery cell 20. The protection circuit module 40 may be on the terrace 31 of the pouch 30 by pivoting or rotating the protection circuit module 40 about the third direction (y-axis). In one or more embodiments, pivoting or rotating the protection circuit module 40 about the third direction (y-axis) may mean that the second surface 52 of the substrate 50 is moved from a direction facing the front surface of the pouch 30 to a direction facing the rear surface of the pouch 30. Pivoting or rotating the protection circuit module 40 about the third direction (y-axis) may mean that the second surface 52 of the substrate 50 is moved from a direction facing the second direction (x-axis) to a direction opposing the second direction (x-axis). Pivoting or rotating the protection circuit module 40 about the third direction (y-axis) may mean that the second surface 52 of the substrate 50 is moved from a direction facing the rear surface of the pouch 30 to a direction facing the front surface of the pouch 30. Pivoting or rotating the protection circuit module 40 about the third direction (y-axis) may mean that the first surface 51 of the substrate 50 is move from the direction opposing the second direction (x-axis) to the direction facing the second direction (x-axis).

Referring back to FIGS. 6, 7, and 9, at least a portion of the second surface 52 of the substrate 50 according to embodiments may be arranged opposite to the module seating surface 311 of the terrace 31. The module seating surface 311 of the terrace 31 may be a surface of the terrace 31 formed in a direction facing the front surface of the pouch 30. The module seating surface 311 of the terrace 31 may be arranged in the second direction x. The module seating surface 311 of the terrace 31 may be a surface of the terrace 31 formed in the second direction x.

The protection circuit module 40 according to embodiments of the present disclosure may be fixed such that the second surface 52 of the substrate 50 is opposite to (e.g., faces away from) the module seating surface 311 of the terrace 31. To fix the protection circuit module 40 such that the second surface 52 of the substrate 50 is opposite to the module seating surface 311, the protection circuit module 40 and the module seating surface 311 may be arranged to overlap in the second direction (x-axis).

The terrace 31, the substrate 50, and the molding portion 70 according to embodiments of the present disclosure may overlap in the second direction (x-axis). The terrace 31, the substrate 50, and the molding portion 70 may be arranged in the stated order in the second direction (x-axis). Heat emitted by the substrate 50 may be discharged in the second direction x. The heat emitted by the substrate 50 may be discharged through the molding portion 70 in the second direction (x-axis). The molding portion 70 may include a material having high thermal conductivity. The molding portion 70 may include a thermally conductive material capable of discharging the heat emitted from the substrate 50 to the outside of the protection circuit module 40. The molding portion 70 may discharge the heat emitted from the substrate 50 to the outside of the battery pack 1.

The substrate 50, the support 60, and the molding portion 70 according to embodiments of the present disclosure may be arranged to overlap in the second direction (x-axis). The substrate 50, the support 60, and the molding portion 70 may be arranged in the stated order in the second direction (x-axis). The support 60 may be between the substrate 50 and the molding portion 70. The support 60 may be on the same surface of the substrate 50 as the protection element 500. The support 60 may be adjacent to the protection element 500 on the first surface 51 of the substrate 50. The support 60 may include a material having high thermal conductivity. The support 60 may include a thermally conductive material capable of discharging the heat emitted from the substrate 50 to the outside of the protection circuit module 40. The support 60 may transfer the heat emitted from the substrate 50 to the molding portion 70. The support 60 may induce the heat emitted from the substrate 50 to be discharged to the outside of the protection circuit module 40. In an embodiment in which the substrate 50, the support 60, and the molding portion 70 are arranged to overlap in the second direction (x-axis), the support 60 may sufficiently transfer or discharge the heat emitted from the substrate 50 to the molding portion 70.

Although the present disclosure has been described with reference to embodiments shown in the drawings, it will be understood by those of ordinary skill in the art that various modifications and equivalent other examples may be made from the shown example.

Although the present disclosure has been described with reference to embodiments shown in the drawings, it will be understood by those of ordinary skill in the art that various modifications and equivalent other examples may be made from the shown example.

The battery pack according to the present disclosure may be configured prevent damage to a substrate by including a support supporting the substrate.

The battery pack according to the present disclosure may provide a protection circuit module capable of efficiently protecting the substrate through the support arranged to avoid a protection element on the substrate.

It should be understood that embodiments described herein should be considered in a descriptive sense only and not for purposes of limitation. Descriptions of features or aspects within each embodiment should typically be considered as available for other similar features or aspects in other embodiments. While one or more embodiments have been described with reference to the figures, it will be understood by those of ordinary skill in the art that various changes in form and details may be made therein without departing from the scope of the present disclosure as defined by the appended claims.

## Claims

1. A battery pack (1) comprising:
a battery cell (20);
a pouch (30) accommodating the battery cell (20), the pouch (30) comprising a terrace (31) along a portion of the pouch (30) in which an electrode of the battery cell (20) extends out of the pouch (30) in a first direction;
a substrate (50) comprising a protection element (500) on a first surface (51) of the substrate (50), the protection element (500) being configured to control charging and discharging of the battery cell (20), wherein a second surface (52) of the substrate (50) opposite to the first surface (51) of the substrate (50) is opposite to a module seating surface (311) of the terrace (31);
a molding portion (70) covering the protection element (500) on the first surface (51); and
at least one support (60) between the molding portion (70) and the substrate (50), the at least one support (60) being configured to support (60) the substrate (50).

2. The battery pack (1) as claimed in claim 1, wherein the substrate (50), the molding portion (70), and the support (60) form a protection circuit module (40).

3. The battery pack (1) as claimed in claim 1 or 2, wherein the module seating surface (311) is a recessed portion on the pouch (30) in a second direction crossing the first direction.

4. The battery pack (1) as claimed in claim 3, wherein the substrate (50) extends lengthwise in a third direction crossing the first direction and the second direction.

5. The battery pack (1) as claimed in claim 4, wherein the support (60) extends lengthwise in the third direction.

6. The battery pack (1) as claimed in any one of the preceding claims, wherein the at least one support (60) comprises a plurality of supports (60).

7. The battery pack (1) as claimed in claim 6, wherein the plurality of supports (60) are spaced apart from each other in the first direction on the first surface (51) of the substrate (50).

8. The battery pack (1) as claimed in any one of the preceding claims, wherein the at least one support (60) does not contact the protection element (500) on the first surface (51) of the substrate (50).

9. The battery pack (1) as claimed in any one of the preceding claims, wherein the at least one support (60) comprises a through-hole structure (61) accommodating the protection element (500).

10. The battery pack (1) as claimed in any one of the preceding claims, wherein the at least one support (60) comprises a metal material.

11. The battery pack (1) as claimed in any one of claims 3 to 5, wherein the terrace (31), the substrate (50), and the molding portion (70) overlap each other in the second direction.

12. The battery pack (1) as claimed in any one of claims 3 to 5 or 11, wherein the substrate (50) is on the terrace (31).

13. The battery pack (1) as claimed in any one of claims 3 to 5, 11 or 12, wherein the molding portion (70) is on the substrate (50) in the second direction.

14. The battery pack (1) as claimed in any one of the preceding claims, wherein the molding portion (70) comprises a thermally conductive material configured to discharge heat emitted from the substrate (50) to an outside of the protection circuit module (40).

15. The battery pack (1) as claimed in any one of the preceding claims, wherein the substrate (50) comprises a connection tab (53) on the second surface (52) and electrically connected to the electrode of the battery cell (20).
